# EUROPEAN PATENT APPLICATION

(11) **EP 4 621 846 A1**
(43) Date of publication of application: **24.09.2025**
(21) Application number: 25164369.8
(22) Date of filing: 18.03.2025
(51) Int. Cl.: H01L 25/065, H01L 21/66, H01L 25/18, H01L 25/00

(54) **SYSTEMS, METHODS, AND DEVICES FOR SEMICONDUCTOR PACKAGING WITH WAFER ON WAFER OPERATIONS**

(30) Priority: 20.03.2024 US 202463567878 P; 06.03.2025 US 202519072996
(71) Applicant: SAMSUNG ELECTRONICS CO., LTD., Yeongtong-gu Suwon-si, Gyeonggi-do 16677 (KR)
(72) Inventor: LI, Yan, San Jose, CA, 95134, (US); KIM, WooPoung, San Jose, CA, 95134 (US)
(74) Representative: Kuhnen & Wacker Patent- und Rechtsanwaltsbüro PartG mbB

(57) **Abstract**

A method may include positioning a first wafer on a second wafer, wherein the first wafer may include a first memory die and the second wafer may include a second memory die, bonding the first memory die and the second memory die to form a memory die stack, and positioning the memory die stack on an interface die. A device may include a first memory device stack comprising a first memory device bonded to a second memory device, a second memory device stack comprising a third memory device bonded to a fourth memory device, and an interface die attached to the first memory device stack and the second memory device stack. A method may include bonding a first memory die to a second memory die, modifying a thickness of the second memory die to form a modified memory die, and bonding a third memory die to the modified memory die.

## Description

### TECHNICAL FIELD

This disclosure relates generally to semiconductor packaging, and more specifically to systems, methods, and devices for semiconductor packaging with wafer on wafer operations.

### BACKGROUND

Some semiconductor packaging techniques may involve combining multiple integrated circuit devices in a package. For example, different types of integrated circuits such as memory devices, processing devices, and/or the like, may be fabricated on separate semiconductor dies using different processes. The dies may be physically and/or electrically connected using various substrates, interposers, interconnects, and/or the like, and enclosed in a package to provide physical, thermal, and/or electrical protection.

The above information disclosed in this Background section is only for enhancement of understanding of the background of the inventive principles and therefore it may contain information that does not constitute prior art.

### SUMMARY

A method may include positioning a first wafer on a second wafer, wherein the first wafer may include a first memory die and the second wafer may include a second memory die, bonding the first memory die and the second memory die to form a memory die stack, and positioning the memory die stack on an interface die. The first memory die may include a first memory device and a second memory device, the second memory die may include a third memory device and a fourth memory device, and bonding the first memory die to the second memory die may include bonding the first memory device to the third memory device and bonding the second memory device to the fourth memory device. The method may further include positioning a second memory die stack on the interface die. The method may further include modifying, based on the positioning the first wafer on the second wafer, a thickness of the second memory die. The method may further include modifying, based on the positioning the first wafer on the second wafer, a thickness of the second memory die, positioning, based on the modifying, a third wafer on the second wafer, wherein the third wafer may include a third memory die, and bonding the second memory die and the third memory die. The method further may include testing the interface die, and the memory die stack may be positioned on the interface die based on the testing the interface die. The method may further include testing, in a third wafer, the interface die, and the memory die stack may be positioned on the interface die based on the testing the interface die. The method may further include bonding the memory die stack and the interface die.

A device may include a first memory device stack comprising a first memory device bonded to a second memory device, a second memory device stack comprising a third memory device bonded to a fourth memory device, and an interface die attached to the first memory device stack and the second memory device stack. The first memory device and the third memory device may be arranged in a die. The device may further include a compute device, and an interposer configured to provide an electrical connection to the compute device and the interface die. The device may further include an interposer connected to the interface die, wherein the interposer may include a redistribution layer. The device may further include an interposer connected to the interface die, wherein the interposer may include a semiconductor structure electrically connected to the interface die. The device may further include an interposer connected to the interface die, wherein the interposer may include a conductive trace. The device may further include an interposer connected to the interface die, wherein the interposer may include a capacitor. The device may further include an interposer connected to the interface die, wherein the interposer may include a regulator.

A method may include bonding a first memory die to a second memory die, modifying a thickness of the second memory die to form a modified memory die, and bonding a third memory die to the modified memory die. The method may further include positioning the third memory die on an interface die. The bonding the first memory die to the second memory die may include bonding a first wafer comprising the first memory die to a second wafer comprising the second memory die. The modifying the thickness of the second memory die may include modifying a thickness of a wafer comprising the second memory die.

A system may include a first die stack comprising two or more bonded first memory dies, a second die stack comprising two or more bonded second memory dies, an interposer, and an interface die arranged to connect the first die stack and the second die stack to the interposer. The two or more bonded first memory dies may include a first memory device bonded to a second memory device. The system may further include a compute device connected to the interposer, wherein the interposer may include a connecting element arranged to connect the compute device to the first die stack. The interface die may include a buffer circuit and a processing circuit.

### BRIEF DESCRIPTION OF THE DRAWINGS

The figures are not necessarily drawn to scale and elements of similar structures or functions or portions thereof may generally be represented by reference indicators ending in, and/or containing, the same digits, letters, and/or the like, for illustrative purposes throughout the figures. The figures are only intended to facilitate the description of the various embodiments described herein. The figures do not describe every aspect of the teachings disclosed herein and do not limit the scope of the claims. To prevent the drawings from becoming obscured, not all of the components, connections, and the like, may be shown, and not all of the components may have reference numbers. However, patterns of component configurations may be readily apparent from the drawings. The accompanying drawings, together with the specification, illustrate example embodiments of the present disclosure, and, together with the description, serve to explain the principles of the present disclosure.
Fig. 1A illustrates an embodiment of a package architecture including a multi-stack memory device in accordance with example embodiments of the disclosure.
Fig. 1B illustrates a cross-sectional view taken through dashed line A-A of the package architecture illustrated in Fig. 1A.
Fig. 2A illustrates a cross sectional view of two wafers for a wafer on wafer process in accordance with example embodiments of the disclosure.
Fig. 2B illustrates a cross sectional view of two bonded wafers in accordance with example embodiments of the disclosure.
Fig. 2C illustrates a cross sectional view of three bonded wafers in accordance with example embodiments of the disclosure.
Fig. 2D illustrates a cross sectional view of N joined wafers in accordance with example embodiments of the disclosure.
Fig. 2E illustrates a cross sectional view of N joined dies in accordance with example embodiments of the disclosure.
Fig. 2F illustrates a cross sectional view of N joined dies having two stacks of memory chips in accordance with example embodiments of the disclosure.
Fig. 3A illustrates a cross sectional view of a wafer in accordance with example embodiments of the disclosure.
Fig. 3B illustrates a cross sectional view of a thinned wafer in accordance with example embodiments of the disclosure.
Fig. 3C illustrates a cross sectional view of a thinned wafer joined to another wafer in accordance with example embodiments of the disclosure.
Fig. 3D illustrates a cross sectional view of two thinned, joined wafers in accordance with example embodiments of the disclosure.
Fig. 3E illustrates a cross sectional view of two thinned, joined wafers and a third joined wafer in accordance with example embodiments of the disclosure.
Fig. 3F illustrates a cross sectional view of three thinned, joined wafers in accordance with example embodiments of the disclosure.
Fig. 3G illustrates a cross sectional view of N thinned, joined wafers in accordance with example embodiments of the disclosure.
Fig. 3H illustrates a cross sectional view of N thinned, joined dies in accordance with example embodiments of the disclosure.
Fig. 3I illustrates a cross sectional view of N thinned, joined dies having two stacks of memory chips in accordance with example embodiments of the disclosure.
Fig. 4A illustrates a cross-sectional view of an embodiment of stacked wafers and/or memory chips fabricated using one or more wafer on wafer and/or wafer thinning techniques in accordance with example embodiments of the disclosure.
Fig. 4B illustrates a cross-sectional view of a first embodiment of stacked memory chips separated from the stacked wafers illustrated in Fig. 4A in accordance with example embodiments of the disclosure.
Fig. 4C illustrates a cross-sectional view of a second embodiment of stacked memory chips separated in groups from the stacked wafers illustrated in Fig. 4A in accordance with example embodiments of the disclosure.
Figs. 5A illustrates a cross-sectional view of an example embodiment of two dies prepared for hybrid bonding in accordance with example embodiments of the disclosure.
Figs. 5B illustrates a cross-sectional view of an example embodiment of two dies in contact for hybrid bonding in accordance with example embodiments of the disclosure.
Fig. 5C illustrates a cross-sectional view of an example embodiment of two dies bonded using hybrid bonding in accordance with example embodiments of the disclosure.
Fig. 6A illustrates a perspective view of wafers for a wafer on wafer process in accordance with example embodiments of the disclosure.
Fig. 6B illustrates a perspective view of a stack of wafers joined using a wafer on wafer process in accordance with example embodiments of the disclosure.
Fig. 6C illustrates a perspective view of a method for singulating a stack of wafers joined using a wafer on wafer process in accordance with example embodiments of the disclosure.
Fig. 6D illustrates a cross-sectional view of an example embodiment of stacks of memory chips fabricated using a wafer on wafer process in accordance with example embodiments of the disclosure.
Fig. 6E illustrates a perspective view of a wafer for performing a die on wafer operation to join a multi-stack memory device and an interface die in accordance with example embodiments of the disclosure.
Fig. 6F illustrates a cross-sectional view of an example embodiment of multi-stack memory device fabricated using a wafer on wafer process in accordance with example embodiments of the disclosure.
Fig. 7 illustrates a cross-sectional view of an embodiment of package architecture including a multi-stack memory device and semiconductor interposer in accordance with example embodiments of the disclosure.
Fig. 8A illustrates a cross-sectional view of an embodiment of package architecture including a multi-stack memory device and redistribution layer interposer in accordance with example embodiments of the disclosure.
Fig. 8B illustrates a plan view of the package architecture illustrated in Fig. 8A.
Fig. 9 illustrates a cross-sectional view of an embodiment of package architecture including a multi-stack memory device and redistribution layer interposer in accordance with example embodiments of the disclosure.

### DETAILED DESCRIPTION

Some semiconductor packaging techniques may combine 2.5D techniques (in which devices may be arranged horizontally on an interposer, substrate, and/or the like) and 3D techniques (in which devices may be stacked vertically). For example, a multi-stack memory device may include two or more stacks of vertically stacked memory dies. The stacks may be arranged side-by-side on an interface die that may include buffer circuitry (e.g., for accessing data stored in the stacks), logic circuitry (e.g., for processing data stored in the stacks), and/or the like.

Dies in a stack of memory device dies may be joined using micro bumps which may result in gaps between dies, thereby reducing thermal conductivity, increasing thermal dissipation, reducing device density, and/or increasing power consumption. The use of micro bumps may also result in a relatively large bump pitch (e.g., distance between adjacent bumps) which may limit bandwidth. Moreover, a stack of memory devices may be fabricated using device on wafer (DoW) techniques that may involve pick and place operations to position individual dies on a wafer which may limit the throughput of fabrication operations.

Some aspects of the disclosure relate to the use of bonding techniques to join dies in a stack of dies. For example, in some embodiments, hybrid bonding techniques may be used to form bonds between metal portions of dies in a stack (e.g., metal-metal bonds) and/or between dielectric portions of dies in a stack(e.g., oxide-oxide bonds). Depending on the implementation details, this may improve thermal performance (e.g., reduce thermal dissipation), reduce the pitch of electrical connections between dies, increase bandwidth between dies, increase device density, and/or the like.

Some additional aspects of the disclosure relate to the use of wafer on wafer (WoW) operations to join dies in a stack of dies. For example, in some embodiments, a first wafer having a first memory die may be stacked on a second wafer having a second memory die aligned with the first memory die. The first and second memory dies may be joined using any suitable interconnect technique such as hybrid bonding between the first and second wafers. In some embodiments, one or more additional dies in the first wafer may be aligned with, and joined to, one or more additional dies in the second wafer. Depending on the implementation details, this may increase manufacturing throughput by enabling one or more layers to be added to multiple die stacks in a WoW operation, thereby reducing or eliminating pick and place operations for individual dies.

In some embodiments, a die used in a WoW operation may include memory devices for two or more stacks. For example, a die may include two or more memory devices, one for each stack that may be used in a multi-stack memory device. Depending on the implementation details, this may reduce the amount of cutting involved in dicing the stacks, improve thermal dissipation, reduce or eliminate the use of molding between stacks of memory dies, and/or the like.

In some embodiments, a wafer on wafer operation in accordance with the disclosure may be performed using reconstructed wafers, panels, and/or other assemblies of dies, or a combination thereof. For example, a wafer on wafer operation may be performed with one or more reconstructed wafers that may be formed from individual dies and/or groups of dies (e.g., tested dies). In some other embodiments, a wafer on wafer operation may be performed with one or more panels of dies that may be fabricated, for example, using techniques similar to wafer reconstruction techniques. Depending on the implementation details, this may increase manufacturing yields, for example, by reducing the number of untested and/or defective dies used during a wafer on wafer operation.

Some additional aspects of the disclosure relate to thinning dies, wafers, and/or the like, used to form stacks of dies. For example, a first wafer may be joined (e.g., bonded) to a second wafer using hybrid bonding. The second wafer may be thinned (e.g., using one or more polishing operations to remove material from the back side of the second wafer), and a third wafer may be joined (e.g., bonded) to the second wafer. Depending on the implementation details, this may improve thermal performance (e.g., reduce thermal dissipation) and/or increase device density in a stack of devices, module, package, and/or the like.

Some additional aspects of the disclosure relate to positioning one or more stacks of devices on one or more interface dies based on testing the interface dies. For example, a wafer having multiple interface dies may be tested to identify good interface dies. One or more stacks of memory dies (which may also be tested to eliminate defective stacks) may be positioned on good interface dies and joined, for example, using DoW techniques such as hybrid bonding, micro bumps, vias (e.g., through silicon vias (TSVs)), and/or the like. Depending on the implementation details, this may reduce fabrication costs, for example, by avoiding waste caused by joining defective stacks and/or interface dies.

Some additional aspects of the disclosure relate to interposers, substrates, and/or the like, used with multi-stack memory devices. For example, one or more multi-stack memory devices may be connected to one or more other integrated circuit devices through an interposer fabricated from glass, silicone, and/or the like, that may include one or more bridges (e.g., silicone bridges) integrated capacitors, voltage regulator modules, and/or the like. As another example, one or more multi-stack memory devices may be connected to one or more other integrated circuit devices through an interposer fabricated as or with a redistribution layer (RDL) that may include one or more bridges (e.g., silicone bridges) integrated capacitors, voltage regulator modules, and/or the like. As a further example, one or more multi-stack memory devices may be connected to one or more other integrated circuit devices through an interposer using one or more conductive traces.

This disclosure encompasses numerous aspects relating to semiconductor packaging. The aspects disclosed herein may have independent utility and may be embodied individually, and not every embodiment may utilize every aspect. Moreover, the aspects may also be embodied in various combinations, some of which may amplify some benefits of the individual aspects in a synergistic manner.

For purposes of illustration, some embodiments may be described in the context of some specific implementation details such as device types, substrate bonding techniques, and/or the like. However, the aspects of the disclosure are not limited to these or any other implementation details. Moreover, although some example embodiments may be described in the context of stacks of memory dies and/or memory devices, some of the aspects may be applicable to other types of dies, devices, and/or the like.

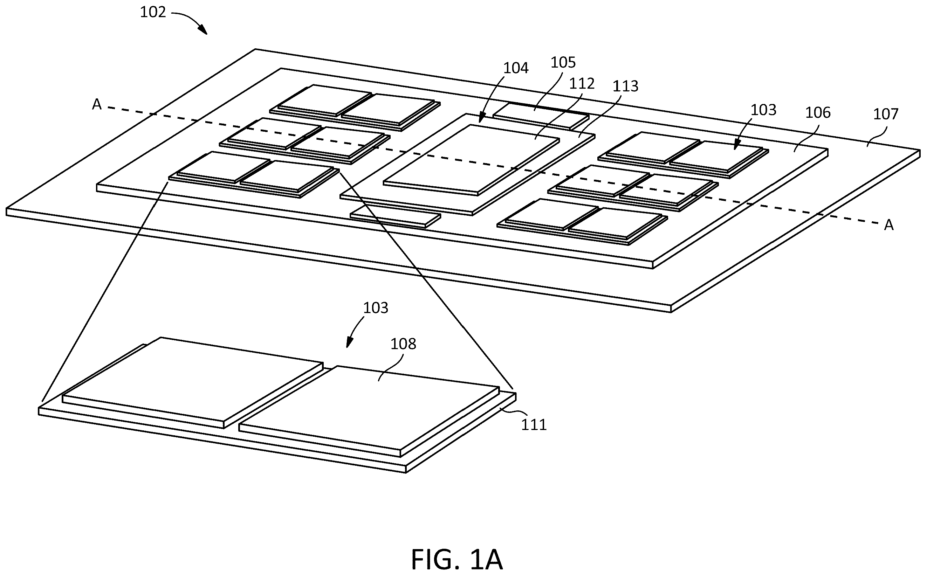

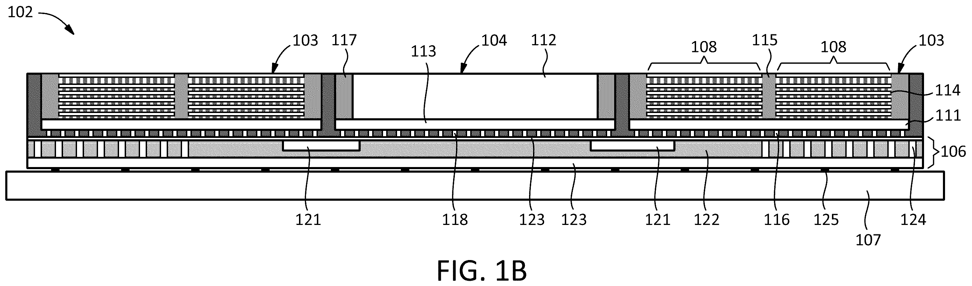

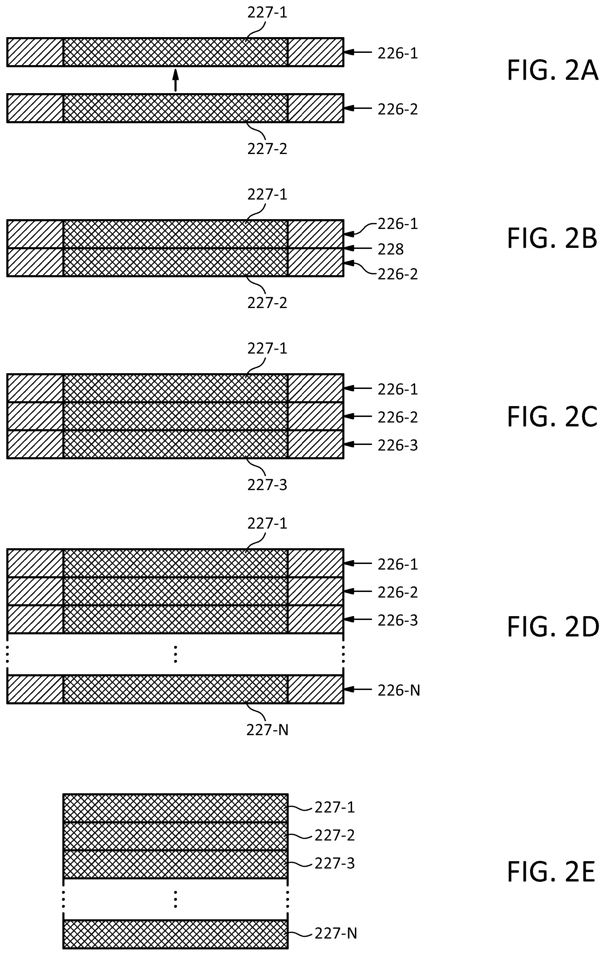

In some example embodiments described here, reference indicators having a base portion and a suffix portion may be referred to collectively and/or individually by the base portion. For example, referring to Fig. 2A, wafers 226-1 and /or 226-2 may be referred to collectively and/or individually as wafer(s) 226. Similarly, multiple figures having the same numbers with different letter suffixes may be referred to collectively and/or individually by the number. For example, Figs. 1A and 1B may be referred to collectively and/or individually as Fig. 1.

Fig. 1A illustrates an embodiment of a package architecture including a multi-stack memory device in accordance with example embodiments of the disclosure. The package architecture 102 may include one or more multi-stack memory devices 103, one or more compute devices 104, and/or one or more input and/or output (I/O or IO) devices 105 arranged on an interposer 106 which may be attached to a substrate 107.

A multi-stack memory device 103 (which may also be referred to as a multi-stack memory module) may include two or more stacks 108 of memory dies arranged on an interface die 111 which may also be referred to as a base die. A compute device 104 may include one or more compute dies 112 arranged on a base die 113.

Fig. 1B illustrates a cross-section taken through dashed line A-A of the package architecture in Fig. 1A. A multi-stack memory device 103 may include two or more stacks 108 of memory dies 114 arranged on an interface die 111. A multi-stack memory device 103 may also include molding 115 that may surround, protect, and/or the like, the memory dies 114. The memory dies 114 may be implemented with any suitable memory devices such as dynamic random access memory (DRAM) devices. The memory dies 114 in a stack 108 may be connected (e.g., mechanically, electrically, thermally, and/or the like) to each other and/or the interface die 111, for example, using micro bumps, TSVs, and/or the like. In some embodiments, a stack 108 of memory dies may be implemented with high bandwidth memory (HBM).

An interface die 111 may include buffer circuitry to access the memory dies 114 and/or logic circuitry to perform one or more functions such as computations and/or any other processing functions. In some embodiments, logic circuitry in an interface die 111 may include custom circuitry to perform one or more functions that may be specified, for example, by a customer.

A multi-stack memory device 103 may be connected (e.g., mechanically, electrically, thermally, and/or the like) to the interposer 106, for example, using micro bumps 116 and/or any other connection techniques.

A compute device 104 may include one or more compute dies 112 that may be implemented for example, with one or more processors (e.g., central processing units (CPUs), graphics processing units (GPUs), neural processing units (NPUs), tensor processing units (TPUs), and/or the like), application specific integrated circuits (ASICs), and/or the like. The one or more compute dies 112 may be connected (e.g., mechanically, electrically, thermally, and/or the like) to the base die 113, for example, using bonding, micro bumps, and/or any other connection techniques. A compute device 104 may also include molding 117 that may surround, protect, and/or the like, the compute dies 112. A compute device 104 may be connected (e.g., mechanically, electrically, thermally, and/or the like) to the interposer 106, for example, using micro bumps 118 and/or any other connection techniques.

The interposer 106 may include one or more connecting elements 121 such as silicon bridges that may provide connections between the multi-stack memory devices 103, compute devices 104, IO devices 105, and/or the like. A connecting element 121 may be formed in or on a substrate 122. The interposer 106 may also include one or more redistribution layers 123 (e.g., at the top and/or bottom of the substrate 122) to provide connections between various components within the package architecture 102. The interposer 106 may also include one or more vias 124 (e.g., TSVs, through organic vias (TOVs), and/or the like) to provide connections between the top and bottom of the substrate 122. The interposer 106 may be connected (e.g., mechanically, electrically, thermally, and/or the like) to the substrate 107, for example, using one or more solder connections 125.

In some embodiments, an interposer may provide one or more signal paths between components such as integrated circuits, stacks of integrated circuits, and/or the like, that may be connected to the interposer. Additionally, or alternatively, an interposer may provide one or more signal paths between a substrate connected to the interposer and one or more components such as integrated circuits, stacks of integrated circuits, and/or the like, that may be connected to the interposer. In some embodiments, an interposer may provide one or more signal paths in the form of conductive traces (e.g., within one or more RDLs), vias, bridges, and/or the like. Depending on the implementation details, an interposer may enable integrated circuits (e.g., chips or chiplets) to be interconnected to form a larger device or system. In some embodiments, an interposer may include a substrate, chip, and/or the like, formed from one or more semiconductors, organic materials, glass, and/or the like.

In some embodiments, a bridge may include a substrate, die, and/or other material having one or more conductive pathways that may form one or more connections between one or more semiconductor devices, substrates, interposers, or other package structures coupled to the bridge. In some embodiments, a bridge may include one or more traces, the traces forming a connection pathway along the bridge between one or more devices coupled to the bridge. In some embodiments, a bridge may be located at least partially on and/or at least partially within (e.g., embedded within) an interposer, substrate, and/or the like.

The package architecture 102 illustrated in Fig. 1A and Fig. 1B may enable faster memory access with higher bandwidth, larger storage capacity, and/or lower power consumption, for example, by enabling memory dies used for cache, static random access memory (SRAM), HBM, and/or the like, to may be placed relatively close to compute dies, by improving memory access by connecting components with semiconductor bridges, and/or by enabling a variety of different types of dies (which may also be referred to as chiplets) to be integrated into a package.

In some embodiments, a stack of memory dies may be fabricated using micro bumps and/or TSVs to connect the individual memory device dies. However, the use of micro bumps may result in solder structures (e.g., solder pillars) that may cause a gap between stacked dies. The gaps between dies may be filled with a substance such as molded underfill (MUF), epoxy molding compound (EMC), and/or the like, which may have relatively low thermal conductivity, thereby reducing thermal conductivity between dies. Thus, the use of micro bumps to connect individual memory device dies may increase power consumption due to relatively high thermal dissipation.

Moreover, it may be difficult to implement micro bumps with a relatively small bump pitch (e.g., distance between adjacent bumps). Depending on the implementation details, this may limit the density of electrical connections between stacked dies, thereby limiting the bandwidth at which data may be transferred within a stack of dies.

In some embodiments, a stack of memory devices may be fabricated using device on wafer (DoW) techniques (which may also be referred to as device to wafer (D2W) techniques) that may involve performing pick and place operations to position individual dies on a wafer. Depending on the implementation details, this may limit the throughput of the fabrication operations. Moreover, the use of micro bumps and/or DoW techniques to join stacked dies may limit the number of dies that may be included in a stack (e.g., to about 16 or fewer dies).

Figs. 2A through 2E illustrate cross-sectional views of embodiments of a method for fabricating a memory die stack, and a device produced thereby, using wafer on wafer techniques in accordance with example embodiments of the disclosure.

Referring to Fig. 2A, a first wafer 226-1 may include a first memory die 227-1, and a second wafer 226-2 may include a second memory die 227-2. The first wafer 226-1 may be stacked on the second wafer 226-2 (as shown by the arrow) with the first memory die 227-1 aligned with the second memory die 227-2 such that one or more interface locations (e.g., conductive pads, via locations (for existing vias and/or vias that may be created with subsequent operations), and/or the like) on the first memory die 227-1 may align with one or more corresponding interface locations on the second memory die 227-2.

Referring to Fig. 2B, the first wafer 226-1 (including the first memory die 227-1) may be joined to the second wafer 226-2 (including the second memory die 227-2) at an interface 228 between the two dies. In some embodiments, the wafers 226 and/or dies 227 may be joined using one or more bonding techniques such as hybrid bonding in which the wafers 226 may be in contact (e.g., direct contact) as illustrated in Fig. 2B. In some other embodiments, the wafers 226 and/or dies 227 may be joined using one or more other techniques such as micro bumps, TSVs, and/or the like, which, depending on the implementation details, may leave a gap between the wafers 226 and/or dies 227.

The assembly of two wafers 226 illustrated in Fig. 2B may be used in embodiments in which a stack of two memory dies 227 may be used, for example, as part of a multi-stack memory device.

Alternatively, the two stacked wafers 226-1 and 226-2 may be stacked with a third wafer 226-3 having a third memory die 227-3 as illustrated in Fig. 2C. The third wafer 226-3 and/or memory die 227-3 may be joined to the second wafer 226-2 and/or second memory die 227-2 using one or more joining techniques including bonding techniques (e.g., hybrid bonding), micro bumps, TSVs, and/or the like, to form a stack having three memory dies 227-1, 227-2, and 227-3.

Alternatively, any number N of wafers 226 and/or dies 227 may be stacked and/or joined using one or more bonding techniques such as hybrid bonding, micro bumps, TSVs, and/or the like, to form a stack having N memory dies 227-1, ..., 227-N as illustrated in Fig. 2D.

Referring to Fig. 2E, the stack of joined memory dies 227 may be removed from the stack of wafers 226 by cutting, dicing, and/or any other process. The stack of joined memory dies 227 may be used, for example, to form a multi-stack memory device by attaching the stack of joined memory dies 227 to an interface die along with one or more additional stacks of joined memory dies 227.

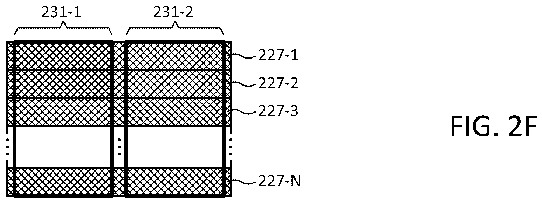

One or more (e.g., each) of the memory dies 227 may include any number of memory devices (e.g., memory integrated circuits (ICs) which may also be referred to as memory chips) such as DRAM chips. For example, in some embodiments, each memory die 227 may include a single DRAM chip such that the stack of joined memory dies 227 illustrated in Fig. 2E is essentially a stack of DRAM chips (which may be referred to as a tower). In some other embodiments, one or more (e.g., each) of the memory dies 227 may include two or more DRAM chips that may form two or more stacks or towers of DRAM chips such as stacks 231-1 and 231-2 illustrated in Fig. 2F.

The wafers 226 illustrated in Fig. 2, as well as any of the wafers disclosed herein, may be implemented with monolithic wafers, reconstructed wafers, panels, and/or the like, or a combination thereof. A monolithic wafer may be fabricated, for example, from a single crystal of semiconductor material in which one or more dies (each including one or more integrated circuits or chips) may be formed. A reconstructed wafer may be fabricated, for example, by attaching multiple dies to a wafer-like carrier (e.g., circular) and using deposition techniques to fill gaps between adjacent dies with one or more materials such as oxides. A panel may be fabricated, for example, using techniques similar to wafer reconstruction techniques to form a panel of dies that may be rectangular or have a shape other than a round wafer. One or more dies used to form a reconstructed wafer, panel, and/or the like, may be tested, for example, to reduce or eliminate defective dies.

As used herein, the term wafer may refer to a monolithic wafer, a reconstructed wafer, a panel, and/or any other aggregation of dies that may be used to implement a wafer on wafer operation as described herein unless otherwise apparent from context.

Depending on the implementation details, the WoW methods described with respect to Figs. 2A through 2F may reduce costs and/or increase throughput associated with fabricating stacks of memory dies, for example, by reducing or eliminating pick and place operations for individual dies with DoW processes. Additionally, or alternatively, the use of bonding techniques such as hybrid bonding may: improve thermal performance by reducing thermal dissipation; reduce the pitch of electrical connections between dies, thereby increasing the density of electrical connections and/or increasing bandwidth between dies; reduce or eliminate gaps between dies, thereby increasing device density and/or enabling the stacking of more dies, and/or the like.

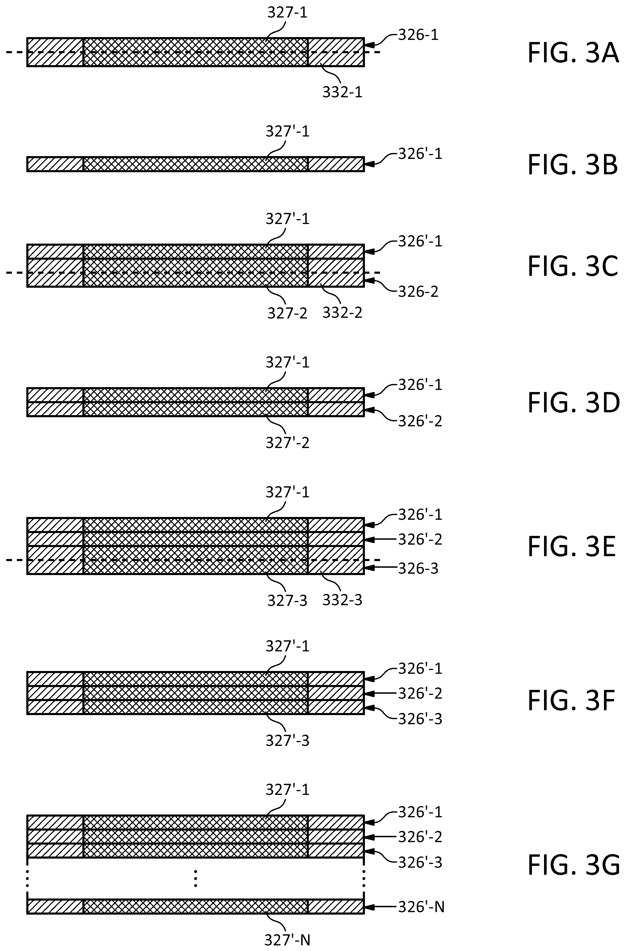

Figs. 3A through 3G illustrate cross-sectional views of embodiments of a method for fabricating a memory die stack, and a device produced thereby, using wafer on wafer and wafer thinning techniques in accordance with example embodiments of the disclosure.

Fig. 3A illustrates a first wafer 326-1 including a first memory die 327-1. A thinning operation may be performed on the wafer 326-1 and/or memory die 327-1 to remove material 332-1 in the portion of the wafer 326-1 and/or memory die 327-1 below the dashed line. The thinning operation may remove material 332-1, for example, from a back side of the memory die 327-1 (e.g., a side without lithography) using any removal process such as polishing (e.g., chemical mechanical polishing (CMP)), etching, and/or the like.

Fig. 3B illustrates the thinned wafer 326'-1 including memory die 327'-1 with material removed.

Fig. 3C illustrates the thinned first wafer 326'-1 including first memory die 327'-1 stacked with a second wafer 326-2 including a second memory die 327-2 aligned with the first memory die 327'-1. The thinned first wafer 326'-1 and/or memory die 327'-1 may be joined with the second wafer 326-2 and/or second memory die 327-2 using one or more techniques similar to those described with respect to Fig. 2 (e.g., hybrid bonding).

Another wafer thinning operation may be performed on the second wafer 326-2 and/or memory die 327-2 to remove material 332-2 in the portion of the wafer 326-2 and/or memory die 327-2 below the dashed line as illustrated in Fig. 3D.

The assembly of two thinned wafers 326'-1 and 326'-2 illustrated in Fig. 3D may be used in embodiments in which a stack of two memory dies 327'-1 and 327'-2 may be used, for example, as part of a multi-stack memory device.

Alternatively, the two thinned stacked wafers 326'-1 and 326'-2 may be stacked with a third wafer 326-3 having a third memory die 327-3 as illustrated in Fig. 3E. The third wafer 326-3 and/or memory die 327-3 may be joined to the thinned second wafer 326'-2 and/or thinned second memory die 327'-2 using one or more joining techniques including bonding techniques (e.g., hybrid bonding), micro bumps, TSVs, and/or the like.

Another wafer thinning operation may be performed on the third wafer 326-3 and/or memory die 327-3 to remove material 332-3 in the portion of the wafer 3263 and/or memory die 327-3 below the dashed line as illustrated in Fig. 3F to form a stack having three thinned memory dies 327'-1, 327'-2, and 327'-3 as illustrated in Fig. 3F.

Alternatively, any number N of wafers 326 and/or dies 327 may be stacked, thinned, and/or joined using one or more thinning and/or joining techniques such as those described with respect to Fig. 2 to form a stack having N memory dies 327'-1, ..., 327'-N as illustrated in Fig. 3G. Although Fig. 3G illustrates an embodiment in which all stacked wafers 326' and/or memory dies 327' may be thinned, in other embodiments, one or more of the stacked wafers 326' and/or memory dies 327' may be used without thinning.

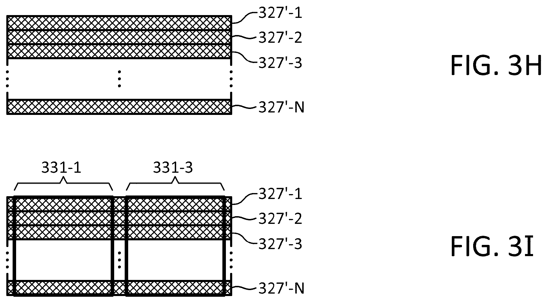

Referring to Fig. 3H, the stack of thinned, joined memory dies 327' may be removed from the stack of thinned, joined wafers 326' by cutting, dicing, singulating, and/or any other process. The stack of thinned, joined memory dies 327' may be used, for example, to form a multi-stack memory device by attaching the stack of thinned, joined memory dies 327 to an interface die along with one or more additional stacks of joined memory dies 327.

One or more (e.g., each) of the thinned memory dies 327' may include any number of memory devices (e.g., memory ICs or memory chips) such as DRAM chips. For example, in some embodiments, each thinned memory die 327' may include a single DRAM chip such that the stack of thinned, joined memory dies 327' illustrated in Fig. 3H is essentially a stack or tower of DRAM chips. In some other embodiments, one or more (e.g., each) of the memory dies 327 may include two or more DRAM chips that may form two or more stacks or towers of thinned DRAM chips such as stacks 331-1 and 331-2 illustrated in Fig. 3I.

As with the embodiments illustrated in Fig. 2, the methods and devices illustrated in Fig. 3 may, depending on the implementation details, reduce costs and/or increase throughput, improve thermal performance, reduce the pitch of electrical connections, reduce or eliminate gaps between dies, and/or the like. Moreover, depending on the implementation details, the methods and devices illustrated in Fig. 3 may further increase density (e.g., by enabling more dies 327' to be included in a stack), improve thermal performance (e.g., by reducing thermal dissipation), improve electrical performance (e.g., by reducing the length of connections between dies), and/or the like, by reducing the thickness of one or more wafers 326' and/or memory dies 327'.

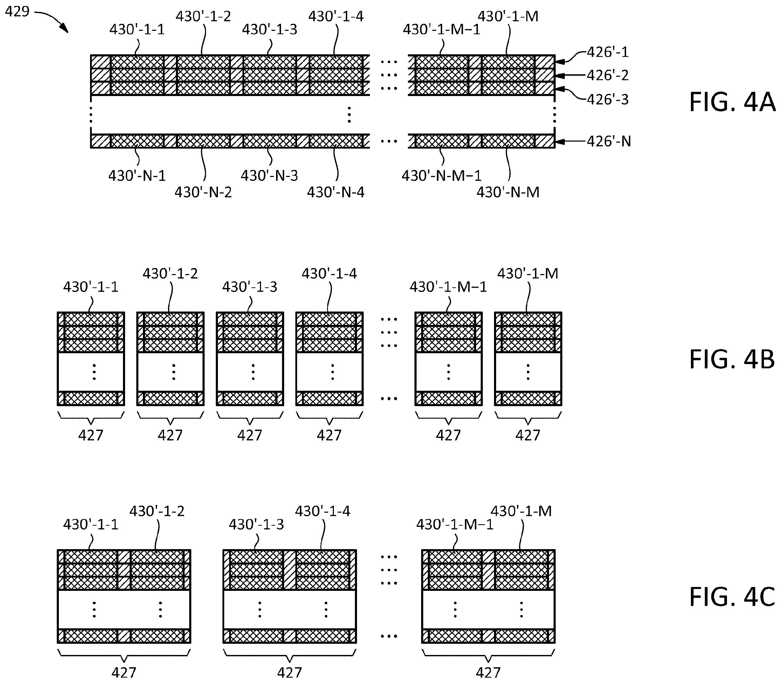

Fig. 4A illustrates a cross-sectional view of an embodiment of stacked wafers and/or memory chips fabricated using one or more wafer on wafer and/or wafer thinning techniques in accordance with example embodiments of the disclosure. The stack 429 of wafers illustrated in Fig. 4A may include any number N of wafers such as thinned wafers 426'-1 through 426'-N. Alternatively, one or more of the wafers 426 may be implemented with wafers that are not thinned. The stack 429 of wafers illustrated in Fig. 4A may be fabricated using any techniques such as those described with respect to Figs. 2 and 3.

The first thinned wafer 426'-1 may include any number M of memory chips 430'-1-1 through 430'-1-M of the same or various types. Similarly, any number (e.g., each) of the other thinned wafers 426'-2 through 426'-N may include any number of memory chips 430' that may be aligned with corresponding chips in the first thinned wafer 426'-1. Any of the thinned wafers 426' and/or memory chips 430' may be joined using one or more joining techniques including bonding techniques (e.g., hybrid bonding), micro bumps, TSVs, and/or the like, to form any number of stacks of memory chips.

Fig. 4B illustrates a cross-sectional view of a first embodiment of stacked memory chips separated from the stacked wafers illustrated in Fig. 4A in accordance with example embodiments of the disclosure. In the embodiment illustrated in Fig. 4B, the stacks of memory chips may be separated as stacks of dies 427 having individual memory chips 430'. For example, the memory chips 430'-1-1 through 430'-N-1 may each be separated as a single die to form a single tower.

Fig. 4C illustrates a cross-sectional view of a second embodiment of stacked memory chips separated in groups from the stacked wafers illustrated in Fig. 4A in accordance with example embodiments of the disclosure. In the embodiment illustrated in Fig. 4C, the stacks of memory chips 430' may be separated from the wafers 426' (e.g., diced) in groups. For example, a first stack of memory chips 430'-1-1 through 430'-N-1 and a second stack of memory chips 430'-1-2 through 430'-N-2 may be separated as a stack of dies 427 such that a layer in the first stack and a corresponding layer in the second stack may be arranged on one die.

Although the view illustrated in Fig. 4C may show stacks of memory chips grouped in a direction parallel to the plane of the drawing, stacks of memory chips may also be grouped in a direction perpendicular to the plane of the drawing.

Depending on the implementation details, separating stacks of memory chips in one or more groups as illustrated in Fig. 4C may improve thermal performance (e.g., by providing thermal conductivity between adjacent stacks and/or chips), reduce processing costs (e.g., by reducing the amount of cutting involved to separate stacks of memory chips and/or reducing the number of assemblies to position on corresponding interface chips and/or wafers), and/or provide other features and/or benefits.

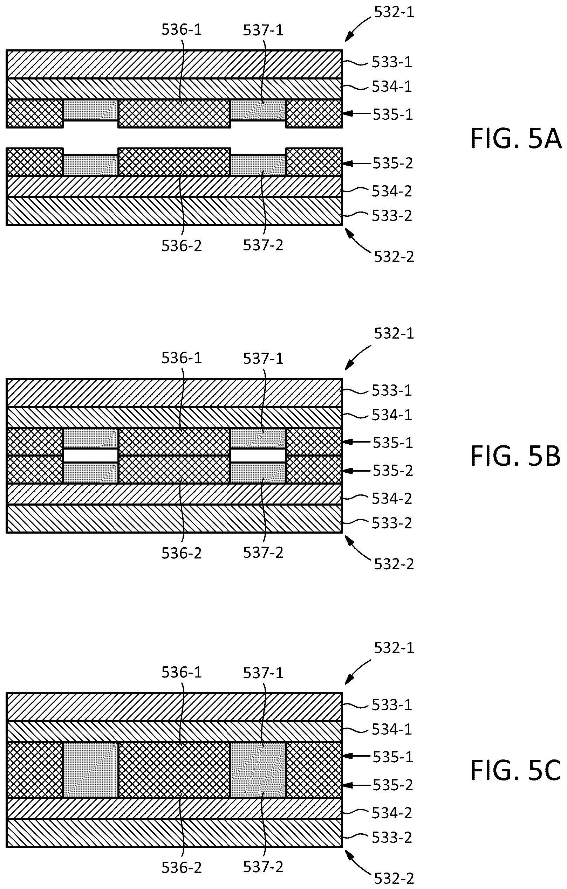

Figs. 5A through 5C illustrate an example embodiment of a method for hybrid bonding in accordance with example embodiments of the disclosure. The embodiment of hybrid bonding (which may also be referred to as direct bond interconnect (DBI)) illustrated in Figs. 5A through 5C may be used, for example, to implement any of the hybrid bonding referenced herein.

Referring to Fig 5A, a first die 532-1 may include a first substrate 533-1, a first interconnect layer 534-1, and/or a first interface layer 535-1 which may include a pattern of dielectric material 536-1 and/or conductive material 537-1. A second die 532-2 may include a second substrate 533-2, a second interconnect layer 534-2, and/or a second interface layer 535-2 which may include a pattern of dielectric material 536-2 and/or conductive material 537-2. The dielectric materials 536 may be implemented, for example, with any dielectric material such as silicon nitride (Si3N4), silicon dioxide (SiO2), and/or the like. The conductive materials 537 may be implemented, for example, with any conductive material including metals such as copper. In some embodiments, a surface of a conductive material 537 may be recessed from a surface of a dielectric material 536 as illustrated in Fig. 5A.

Referring to Fig. 5B, the first and second dies 532-1 and 532-2 may be moved together (e.g., by pressing the dies together) such that the patterns of dielectric materials 536-1 and 536-2 on opposing dies are brought into contact. In this configuration the dies may be held together, for example, by relatively weak initial bonds (e.g., hydrogen bonds) between the dielectric materials 536. Additionally, or alternatively, in this configuration, there may be gaps between the conductive materials 537-1 and 537-s on opposing dies, for example, because of the initially recessed surfaces of the conductive materials 537.

Referring to Fig. 5C, the first and second dies 532-1 and 532-2 may be heated and/or pressed together using additional force to form relatively stronger bonds (e.g., covalent bonds) between the dielectric materials 536 on opposing dies. Additionally, or alternatively, the conductive materials 537-1 and 537-2 may expand which may cause contact between the conductive materials 537-1 and 537-2 on opposing dies 532-1 and 532-2, thereby forming one or more electrical connections. In some embodiments, heat and/or pressure applied to the dies 532 may cause annealing of the conductive materials 537. Depending on the implementation details, conductive materials 537-1 and 537-2 on opposing dies 532 may fuse.

In some embodiments, and depending on the implementation details, wafers and/or dies joined using hybrid bonding techniques such as those illustrated in Figs. 5A through 5C may be referred to, and/or characterized as, gapless wafers, dies, stacks, towers, and/or the like.

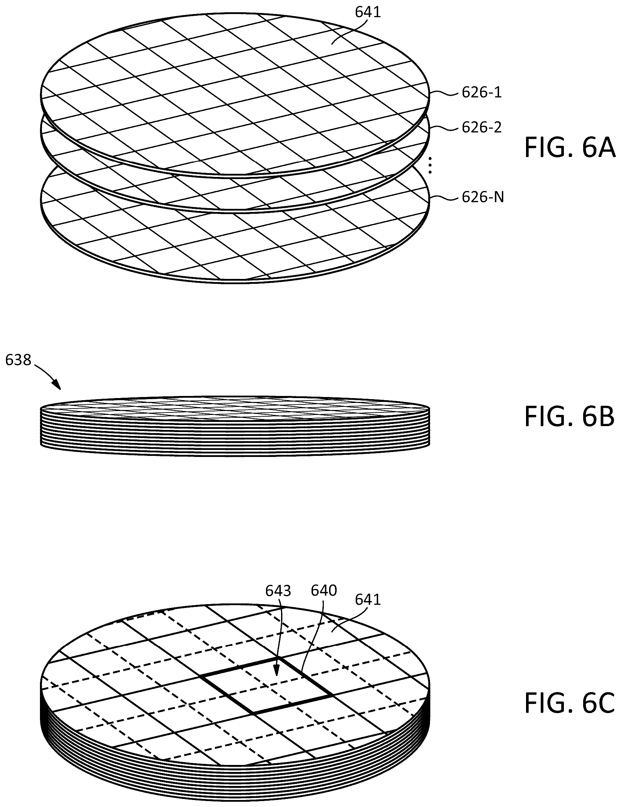

Figs. 6A through 6F illustrate perspective and/or cross-sectional views of embodiments of a method for fabricating a multi-stack memory device, and devices produced thereby, using wafer on wafer and/or wafer thinning techniques in accordance with example embodiments of the disclosure.

Referring to Fig. 6A, any number N of individual wafers 626-1, ... 626-N may be fabricated with any number of memory chips 641. In some embodiments, one or more of the individual wafers 626 may be fabricated as monolithic wafers. Additionally, or alternatively, one or more of the wafers 626 may be fabricated as reconstructed wafers, panels, and/or the like. For example, if there is a yield issue with a fabrication process for a monolithic wafer (e.g., a relatively large number of defective memory chips 641), a reconstructed wafer may be used because a reconstructed wafer may be fabricated using memory chips 641 that have tested good (e.g., without a threshold amount of defects).

Referring to Fig. 6B, any number N of wafers 626 may be stacked and joined (e.g., using a bonding technique such as hybrid bonding) to form a stack of wafers 638. For example, 4-16 or more wafers 626 may be stacked and joined, for example, using any of the techniques described herein, including those described with respect to Figs. 2 through 5.

In some embodiments, one or more (e.g., all) of the wafers 626 illustrated in Fig. 6B may be thinned. For example, in some embodiments, a first wafer 626-1 may be thinned and used as the first wafer in the stack 638. Each time a new wafer 626 is bonded to the stack 638 of previously bonded wafers 626, the new wafer 626 may be thinned. In some example embodiments, one or more (e.g., each) wafer 626 may be thinned, e.g., to a thickness of a few tens of micrometers, (µm) to a few µm, or less. An additional wafer 626, if any, may be bonded to the previously thinned wafer 626 until the stack 638 of wafers reaches a specified number of wafers.

Referring to Fig. 6C, the stack 638 of joined and thinned wafers may be cut apart (e.g., diced) to form one or more stacks of dies having one or more memory chips 641. In the example embodiment illustrated in Fig. 6C, the stack 638 of joined and thinned wafers may be cut along the solid lines (leaving the dashed lines uncut) to form one or more stacks of dies having four memory chips 641 each. Thus, each stack of dies (an example 643 of which is outlined by the heavy solid line 640) may include four stacks or towers of memory chips 641.

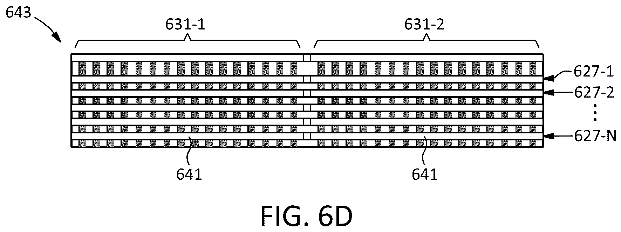

Fig. 6D illustrates a cross-sectional view of the example stack 643 of dies illustrated in Fig. 6C. In the cross-sectional view, two stacks or towers 631-1 and/or 631-2 of memory chips 641 may be visible. One or more (e.g., each) layer of the stack 643 may include a die 627 having two memory chips 641.

In some embodiments, one or more (e.g., all) of the stack 643 of dies 627 may be tested to reduce or eliminate stacks 643 having defective memory chips 641. In some embodiments, a stack 643 that tests good may be referred to, and/or characterized as, a known good stack (KGS).

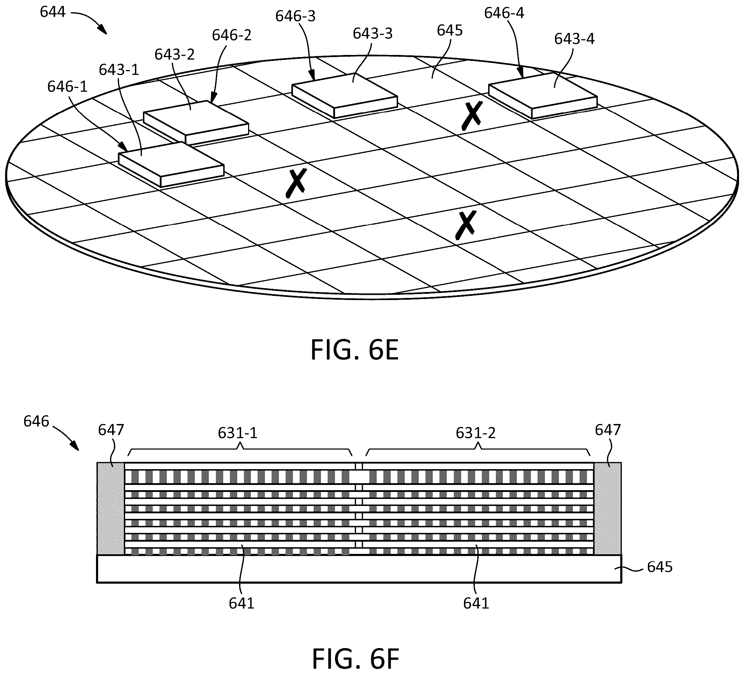

Referring to Fig. 6E, a wafer 644 may be fabricated with one or more interface dies 645 which may be implemented, for example, with an interface die 111 illustrated in Fig. 1 and/or any other interface die disclosed herein. In some embodiments, one or more (e.g., all) of the interface dies 645 may be tested to identify known good dies (KGDs) and/or defective dies indicated by "X"s in Fig. 6E. In some embodiments, a customer may specify (e.g., design) one or more custom functions for one or more interface dies 645.

One or more stacks 643 of dies 627 may be positioned on, and joined to, one or more interface dies 645. For example, in some embodiments, one or more known good stacks 643 (e.g., only good stacks) may be positioned on (e.g., using a pick and place operation), and joined to, one or more known good interface dies 645 (e.g., only good interface dies), some examples of which are indicated as stacks 643-1, through 643-4 in Fig. 6E. Stacks 643 may be joined to interface dies 645 using, for example, DoW techniques such as one or more bonding techniques (e.g., hybrid bonding), micro bumps (e.g., solder), TSVs, and/or the like, to form one or more multi-stack memory devices such as devices 646-1 through 646-4 illustrated in Fig. 6E.

In some embodiments, a molding material such as MUF, EMC, and/or the like, may be applied to the wafer 644 to fill one or more gaps between stacks 643 located on interface dies 645.

The wafer 644 having stacks 643 joined to interface dies 645 may be cut apart (e.g., diced, which may also be referred to as singulation) to form one or more multi-stack memory devices 646.

Fig. 6F illustrates a cross-sectional view of one of the multi-stack memory devices 646 formed as illustrated in Fig. 6E. Referring to Fig. 6F, two stacks or towers 631-1 and/or 631-2 of memory chips 641 may be visible in the stack 643 on the interface die 645. The multi-stack memory devices 646, which may also include molding compound 647, may be further assembled, for example, into a package architecture such as package architecture 102 illustrated in Fig. 1 and/or any other package architecture disclosed herein.

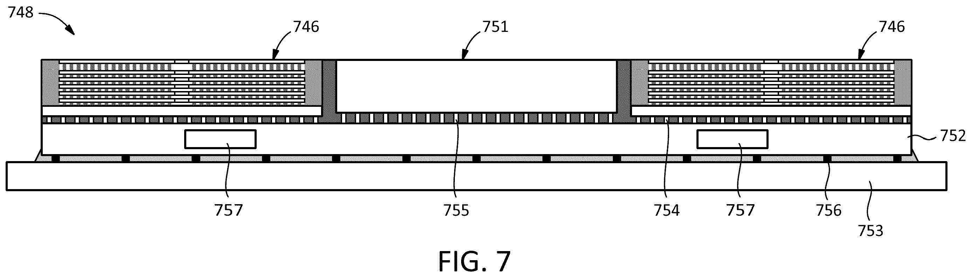

Fig. 7 illustrates a cross-sectional view of an embodiment of package architecture including a multi-stack memory device and semiconductor interposer in accordance with example embodiments of the disclosure. The package architecture 747 illustrated in Fig. 7 may use one or more multi-stack memory devices that may be fabricated, for example, using any of the wafer and/or panel level packaging techniques described herein, including those described with respect to Figs. 2 through 6.

Referring to Fig. 7, the package architecture 747 may include one or more multi-stack memory devices 746, one or more compute devices 751, an interposer 752, and/or a substrate 753.

The interposer 752 may be implemented, for example, as a semiconductor (e.g., silicon) interposer. In some embodiments, a semiconductor interposer may include one or more capacitors 757 (e.g., an integrated stack capacitor (ISC) fabricated in one or more layers of a silicon interposer) which, depending on the implementation details, may improve the performance of one or more power delivery networks (PDNs) in the interposer 752, one or more one or more multi-stack memory devices 746, one or more compute devices 751, and/or substrate 753.

The one or more multi-stack memory devices 746 may be joined to the interposer 752 using any suitable joining techniques such as micro bumps (e.g., solder) 754 as illustrated in Fig. 7, bonding (e.g., hybrid bonding), TSVs, and/or the like. The one or more compute devices 751 may also be joined to the interposer 752 using any suitable joining techniques such as micro bumps (e.g., solder) 755 as illustrated in Fig. 7, bonding (e.g., hybrid bonding), TSVs, and/or the like. The interposer 752 may be joined to the substrate 753 using any suitable joining techniques such as micro bumps (e.g., solder) 756 as illustrated in Fig. 7, bonding (e.g., hybrid bonding), TSVs, and/or the like.

The substrate 753 may be implemented, for example, as an organic substrate, a glass substrate, a semiconductor (e.g., silicon) substrate, and/or the like, or combination thereof. In some embodiments, one or more liquid cooling channels may be formed in the substrate 753 to improve thermal performance.

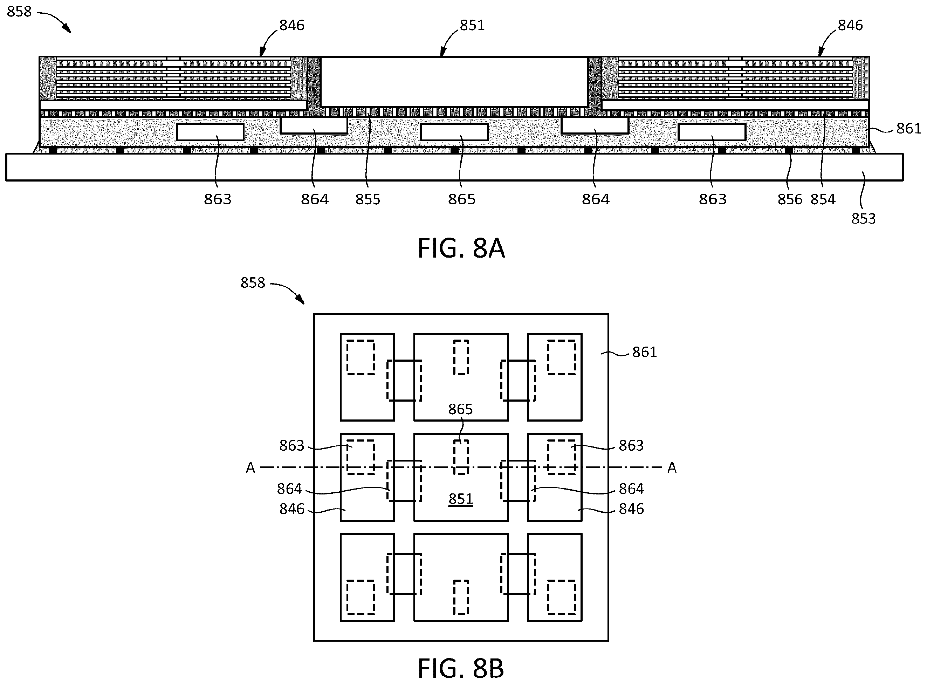

Fig. 8A illustrates a cross-sectional view of an embodiment of package architecture including a multi-stack memory device and redistribution layer interposer in accordance with example embodiments of the disclosure. Fig. 8B illustrates a plan view of the package architecture illustrated in Fig. 8A. The cross-sectional view illustrated in Fig. 8A is taken through the dashed line shown in Fig. 8B. The package architecture 858 illustrated in Figs. 8A and 8B may use one or more multi-stack memory devices that may be fabricated, for example, using any of the wafer and/or panel level packaging techniques described herein, including those described with respect to Figs. 2 through 6.

Referring to Fig. 8A, the package architecture 858 may include one or more multi-stack memory devices 846, one or more compute devices 851, an interposer 861, and/or a substrate 853.

The interposer 861 may be implemented, for example, with one or more RDLs that may be embedded with one or more ISCs 863, one or more semiconductor (e.g., silicon) bridges 864, and/or one or more voltage regulation modules (VRMs) 865. In some embodiments, the one or more ISCs 863 and/or one or more VRMs 865 may improve the performance of one or more PDNs in the interposer 861, one or more one or more multi-stack memory devices 846, one or more compute devices 851, and/or substrate 853. In some embodiments, the one or more semiconductor bridges 864 may provide relatively dense die to die connections between any of the one or more multi-stack memory devices 846 and any of the one or more compute devices 851.

In some embodiments, an RDL may be implemented with one or more layers of dielectric and one or more layers of conductors. For example, an RDL may include a first layer of dielectric material that may function as a substrate or base for the RDL structure. A layer of conductive traces (e.g., using metal such as copper) may be formed (e.g., using one or more deposition and/or patterning techniques) on the dielectric layer to create a network of electrical connections. One or more additional layers of dielectric material and/or conductive material may be formed over the first dielectric layer and/or the first conductive layer depending on the number and/or complexity of connections to be used in the RDL.

The one or more multi-stack memory devices 846 may be joined to the interposer 861 using any suitable joining techniques such as micro bumps (e.g., solder) 854 as illustrated in Fig. 8, bonding (e.g., hybrid bonding), TSVs, and/or the like. The one or more compute devices 851 may also be joined to the interposer 861 using any suitable joining techniques such as micro bumps (e.g., solder) 855 as illustrated in Fig. 8, bonding (e.g., hybrid bonding), TSVs, and/or the like. The interposer 861 may be joined to the substrate 853 using any suitable joining techniques such as micro bumps (e.g., solder) 856 as illustrated in Fig. 8, bonding (e.g., hybrid bonding), TSVs, and/or the like.

The substrate 853 may be implemented, for example, as an organic substrate, a glass substrate, a semiconductor (e.g., silicon) substrate, and/or the like, or combination thereof. In some embodiments, one or more liquid cooling channels may be formed in the substrate 853 to improve thermal performance.

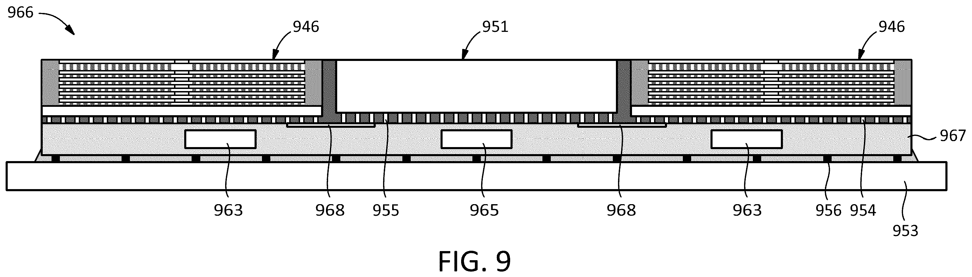

Fig. 9 illustrates a cross-sectional view of an embodiment of package architecture including a multi-stack memory device and redistribution layer interposer in accordance with example embodiments of the disclosure. The package architecture 962 illustrated in Fig. 9 may use one or more multi-stack memory devices that may be fabricated, for example, using any of the wafer and/or panel level packaging techniques described herein, including those described with respect of Figs. 2 through 6.

Referring to Fig. 9, the package architecture 966 may include one or more elements that may be similar to those illustrated in Fig. 8 in which similar elements may be indicated by reference numbers ending in, and/or containing, the same digits, letters, and/or the like. However, in the embodiment illustrated in Fig. 9, the RDL 967 may include one or more connecting elements in the form of conductive traces 968 that may be used in addition to, or as an alternative to, one or more other connecting elements such as the semiconductor bridges 864 illustrated in Fig. 8. Depending on the implementation details, the one or more conductive traces 968 may provide relatively dense die to die connections between any of the one or more multi-stack memory devices 946 and any of the one or more compute devices 951. However, depending on the implementation details, the one or more conductive traces 968 may be less expensive to implement compared to the semiconductor bridges 864 and/or may simplify a fabrication process flow for the package architecture 962. In some example embodiments, the one or more conductive traces 968 may be implemented with a relatively dense line spacing (L/S) in the RDL layer that may provide acceptable die to die connections without using semiconductor bridges.

In some example embodiments, WoW and/or DoW joining (e.g., bonding) may be used to produce a multi-stack memory device that may be implemented as a module, for example, with one or more stacks of memory dies (e.g., one or more stacks of HBM memory). A multi-stack memory device may include a base die having buffer circuitry and/or logic circuitry. In some embodiments, at least a portion of the logic circuitry may be customized (e.g., designed by a customer).

Depending on the implementation details, one or more gaps between memory dies in a stack of memory dies may be reduced or eliminated, for example, through the use of bonding such as one or more hybrid bonding processes.

In some embodiments, a multi-stack memory device may include any number (e.g., one, two, three, four, or more stacks (e.g., towers) of memory dies and/or chips which may be integrated (e.g., on an interposer) in a package along with one or more compute devices (e.g., a processor, ASIC die, and/or other types of chiplets, capacitors (e.g., ISCs), bridges (e.g., semiconductor bridges such as silicon bridges), regulator modules (e.g., VRMs), and/or the like.

Some embodiments may accommodate stacks with a relatively large number of memory dies (e.g., up to, or greater than, 16 DRAM dies) while possibly reducing power consumption, which, depending on the implementation details, may enable further improvement in memory bandwidth and/or other performance of the microelectronic devices. Additionally, or alternatively, the aspects of the disclosure may improve manufacturing throughput times for multi-stack memory devices through the use of wafer level bonding process. Furthermore, depending on the implementation details, thermal performance may be improved by the reduction or elimination of chip gaps, underfill, and/or any other materials between vertically stacked memory dies.

Some embodiments in accordance with the disclosure may provide a package assembly process including, for example, stacking memory wafers to create one or more memory chip towers which may be bonded to an interface die (which may include logic and/or buffer circuitry) to produce multi-stack memory devices with reduced or eliminated gaps between stacked dies.

In some embodiments, advanced packaging architectures may be implemented to generate multi-stack memory devices that may integrate memory, compute functionality (e.g., ASIC), ISC, VRM, and/or semiconductor (e.g., Si) bridges with wafer or panel level processes which may utilize different substrates, including organic, Si, and/or glass. Examples of applications for the aspects disclosed herein may include CPUs, GPUs, AI chips (e.g., NPUs, TPUs, and/or the like), system on chip (SoC), system-in-package (SIP), and/or other applications.

In some embodiments, a multi-stack memory device may include custom logic circuitry on an interposer, reduced or eliminated gaps between stacked devices, and/or reduced bump pitch for vertical connections between dies, any or all of which may provide increased bandwidth. Additionally, or alternatively, underfill and/or other material may be reduced or eliminated between vertically stacked dies which depending on the implementation details, may improve thermal performance.

In some embodiments, a multi-stack memory device, which may include custom logic circuitry, may be produced using one or more WoW processes which, depending on the implementation details, may increase manufacturing throughput.

In some embodiments, a thinning process such as CMP may be used to thin down one or more wafers and/or dies (e.g., to less than a few micrometers or thinner) between bonding operations which, depending on the implementation details, may increase the number of dies that may be stacked.

In some embodiments, a multi-stack memory device may have increased bandwidth and/or reduced power consumption. Additionally, or alternatively, in some embodiments, customized logic may be implemented in a base die of a multi-stack memory device which may be designed by a customer to improve performance with less power consumption.

In some embodiments, an embedded or built-in ISC in an interposer may improve the operation of one or more PDNs. Additionally, or alternatively, a VRM may be included in an RDL interposer which, depending on the implementation details, may further improve power performance, integrity, and/or the like.

In some embodiments, silicon (Si) and/or glass substrates may be used which, depending on the implementation details, may enable the production of larger packages. In some embodiments, liquid cooling channels may be embedded substrates (e.g., Si and/or glass substrates) to further improve thermal performance.

Examples of applications for the aspects disclosed herein may include: CPUs, GPUs, AI chips (e.g., NPUs, TPUs, and/or the like), ASIC chips, and/or other applications that may benefit from increased memory bandwidth and/or high power; automotive and/or radio frequency (RF) chips that may benefit from greater reliability under relatively harsh operating conditions, datacenter applications that may benefit from larger packages, and/or the like.

Some embodiments disclosed above have been described in the context of various implementation details, but the principles of this disclosure are not limited to these or any other specific details. For example, some functionality has been described as being implemented by certain components, but in other embodiments, the functionality may be distributed between different systems and components in different locations and having various interfaces. Certain embodiments have been described as having specific processes, operations, etc., but these terms also encompass embodiments in which a specific process, operation, etc. may be implemented with multiple processes, operations, etc., or in which multiple processes, operations, etc. may be integrated into a single process, step, etc. A reference to a component or element may refer to only a portion of the component or element. For example, a reference to a block may refer to the entire block or one or more subblocks. The use of terms such as "first" and "second" in this disclosure and the claims may only be for purposes of distinguishing the elements they modify and may not indicate any spatial or temporal order unless apparent otherwise from context. In some embodiments, a reference to an element may refer to at least a portion of the element, for example, "based on" may refer to "based at least in part on," and/or the like. A reference to a first element may not imply the existence of a second element. The principles disclosed herein have independent utility and may be embodied individually, and not every embodiment may utilize every principle. However, the principles may also be embodied in various combinations, some of which may amplify the benefits of the individual principles in a synergistic manner. The various details and embodiments described above may be combined to produce additional embodiments according to the inventive principles of this patent disclosure.

In some embodiments, a portion of an element may refer to less than, or all of, the element. A first portion of an element and a second portion of the element may refer to the same portions of the element. A first portion of an element and a second portion of the element may overlap (e.g., a portion of the first portion may be the same as a portion of the second portion).

Since the inventive principles of this patent disclosure may be modified in arrangement and detail without departing from the inventive concepts, such changes and modifications are considered to fall within the scope of the following claims.

## Claims

1. A method comprising:
positioning a first wafer on a second wafer, wherein the first wafer comprises a first memory die and the second wafer comprises a second memory die;
bonding the first memory die and the second memory die to form a memory die stack; and
positioning the memory die stack on an interface die.

2. The method of claim 1, wherein:
the first memory die comprises a first memory device and a second memory device;
the second memory die comprises a third memory device and a fourth memory device; and
bonding the first memory die to the second memory die comprises bonding the first memory device to the third memory device and bonding the second memory device to the fourth memory device.

3. The method of claim 1 or 2, further comprising positioning a second memory die stack on the interface die.

4. The method of any one of claims 1 to 3, further comprising modifying, based on the positioning the first wafer on the second wafer, a thickness of the second memory die.

5. The method of any one of claims 1 to 3, further comprising:
modifying, based on the positioning the first wafer on the second wafer, a thickness of the second memory die;
positioning, based on the modifying, a third wafer on the second wafer, wherein the third wafer comprises a third memory die; and
bonding the second memory die and the third memory die.

6. The method of any one of claims 1 to 5, wherein:
the method further comprises testing the interface die; and
the memory die stack is positioned on the interface die based on the testing the interface die.

7. The method of any one of claims 1 to 5, wherein:
the method further comprises testing, in a third wafer, the interface die; and
the memory die stack is positioned on the interface die based on the testing the interface die.

8. The method of any one of claims 1 to 7, further comprising bonding the memory die stack and the interface die.

9. A device comprising:
a first memory device stack comprising a first memory device bonded to a second memory device;
a second memory device stack comprising a third memory device bonded to a fourth memory device; and
an interface die attached to the first memory device stack and the second memory device stack.

10. The device of claim 9, wherein the first memory device and the third memory device are arranged in a die.

11. The device of claim 9 or 10, further comprising:
a compute device; and
an interposer configured to provide an electrical connection to the compute device and the interface die.

12. The device of claim 9 or 10, further comprising an interposer connected to the interface die, wherein the interposer comprises a redistribution layer.

13. The device of claim 9 or 10, further comprising an interposer connected to the interface die, wherein the interposer comprises a semiconductor structure electrically connected to the interface die.

14. The device of claim 9 or 10, further comprising an interposer connected to the interface die, wherein the interposer comprises a conductive trace.

15. The device of claim 9 or 10, further comprising an interposer connected to the interface die, wherein the interposer comprises a capacitor.
